(19) **Europäisches Patentamt / European Patent Office / Office européen des brevets**

(11) **EP 2 699 069 B1**

(12) # EUROPEAN PATENT SPECIFICATION

(45) Date of publication and mention
of the grant of the patent:
**07.11.2018 Bulletin 2018/45**

(21) Application number: **12771402.0**

(22) Date of filing: **06.03.2012**

(51) Int Cl.:
*H05K 13/04* *(2006.01)*    *H05K 13/08* *(2006.01)*

(86) International application number:
**PCT/JP2012/055716**

(87) International publication number:
**WO 2012/140975 (18.10.2012 Gazette 2012/42)**

(54) **COMPONENT-MOUNTING DEVICE**

VORRICHTUNG ZUR MONTAGE VON BAUTEILEN

DISPOSITIF DE MONTAGE DE COMPOSANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.04.2011  JP 2011089551**

(43) Date of publication of application:
**19.02.2014  Bulletin 2014/08**

(73) Proprietor: **FUJI Corporation
Chiryu
Aichi (JP)**

(72) Inventors:
• **KAWAI, Hidetoshi
Chiryu-shi, Aichi 472-8686 (JP)**

• **AKATSUKA, Ryota
Chiryu-shi, Aichi 472-8686 (JP)**

(74) Representative: **Grünecker Patent- und
Rechtsanwälte
PartG mbB
Leopoldstraße 4
80802 München (DE)**

(56) References cited:
**JP-A- H07 307 598       JP-A- 2007 012 889
JP-A- 2007 103 436       JP-A- 2009 135 267
US-A1- 2001 001 167**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

# EP 2 699 069 B1

## Description

### TECHNICAL FIELD

The present invention relates to a component mounter according to the preamble of claim 1, as it is known from US 2001/001167 A1. A component mounter of such type takes images of components being held on suction nozzles using a camera, recognizes the pickup position of said components using image processing, and mounts the components on a circuit board. Related component mounters are known from JP H07 307 598 A or JP 2007 103436 A.

### BACKGROUND TECHNOLOGY

For example, with rotary head type (revolving head type) electronic component mounters, as disclosed in Prior Art 1 (Japanese published unexamined patent application number 2010-199630), in order to reduce the number of times images are taken of components being held on suction nozzles and thereby improve productivity, multiple components each being held by a suction nozzle of a rotary head equipped with multiple suction nozzles are gathered within the same field of view of a camera and an image taken of all the components at the same time; the signal of this image is then processed and the pickup position of each of the multiple components is recognized, and each component is then mounted on the circuit board considering the deviation of the pickup position (that is, the deviation between the center of the component and the center of the suction nozzle).

### PRIOR ART REFERENCES

### PRIOR ART

Prior Art 1: Japanese published unexamined patent application number 2010-199630

### BRIEF SUMMARY OF THE INVENTION

### PROBLEM SOLVED BY INVENTION

With the electronic component mounter from Prior Art 1 above, a single image of all the components is taken using a camera, with the multiple components held on multiple suction nozzles illuminated by a dome-shaped (bowl-shaped) light source from below. With this mounter, the configuration is such that the center of the camera field of view (image center) and the center of the light source are aligned; however, when gathering multiple components into the same camera field of view and taking a single image of all the components, the image is taken such that the position of each component is misaligned with the center of the camera field of view (center of the light source).

If a component of which an image is to be taken is a BGA-type component, the pickup position of the component is recognized by recognizing the bumps arranged in specific positions on the bottom surface of the component; however, because the position of the component when the image is taken is misaligned with the center of the camera field of view (center of the light source), the light and dark condition (shading) of the bumps due to the illumination changes based on the distance from the center of the field of view (the exposure angle with respect to the light source); as a result, the recognized position of the component of which an image is taken by the camera is deviated. Also, if the height position from the light source at which the image is taken changes, the exposure angle with respect to the light source changes, and the recognized position of the component is deviated.

Also, there are cases in which the recognized position of the component is deviated if the component type is changed. For example, when recognizing the position of curved sections of components such as BGA-type components with bumps or the electrodes of chip capacitors, the light and dark condition (due to the light source) of the sections used for recognition changes based on the size of the curvature, and the recognized position of the component is deviated. If the recognized position of the component is deviated, the mounting position accuracy of the component to be mounted on the circuit board deteriorates by that amount.

With respect to this, for the problem to be solved by this invention, what is proposed is an electronic component mounter equipped with a function for correcting the deviation of the recognized position of a component caused by the effect of the light source.

### MEANS OF SOLVING THE PROBLEM

In order to solve the above problem, the invention provides the component mounter according to claim 1. Preferred embodiments are claimed in the subclaims. A component mounter disclosed herein is equipped with a camera to take images of components being held on suction nozzles illuminated by a light source from below and an image processing means to process the image signal of said camera in order to recognize the pickup position of the components. The electronic component mounter mounts said components on a circuit board considering the deviation of the pickup position of said components with respect to said suction nozzles based on the recognition results of the image processing means; the mounter being configured such that it is equipped with a recognized position deviation correction means for correcting the deviation in the recognized position of said components due to the positional relationship between the component and the light source which considers the deviation in the recognized position of said components of which an image is taken by said camera caused by the changing light and dark condition of the component (due to the light source) due to the positional relationship between the light source and the components being held by said suction nozzles.

With this configuration, even if a deviation arises in the recognized position of a component due to changes in the light and dark condition (shading) of the component (due to the light source) due to the positional relationship between the light source and the components being held by the suction nozzles, correction of the recognized position deviation of the component due to the positional relationship of the light source and the component can be performed using the recognized position deviation correction means; therefore, the mounting accuracy when mounting the component on the circuit board can be improved.

However, there are cases in which an image is taken by the camera of a single component being held by a single suction nozzle and the pickup position of that component recognized. In this case, it is possible to take the image with the single component being held by a single suction nozzle in the center of the camera field of view (center of the light source). Therefore, when the component and the center of the camera field of view are aligned, virtually no deviation arises in the recognized position of the component due to the effects of the light source, which means that there is no need to correct for the deviation in the recognized position of the component; however, when the component and the center of the camera field of view are not aligned, a deviation does arise in the recognized position of the component due to the effects of the light source, which means that, by using the present invention, it is possible to correct for the deviation in the recognized position of the component due to the positional relationship of the light source and the component.

Also, when gathering multiple components each being held by one of multiple suction nozzles into the same camera field of view and taking a single image of all the components, because it is impossible to take an image with each of the components in the center of the camera field of view (center of the light source) at the same time, a deviation arises in the recognized position of the components which are misaligned with the center of the camera field of view (center of the light source). Therefore, when taking a single image of multiple components, by using the present invention, it is possible to correct for the deviation in the recognized position of the multiple components of which a single image is taken, this making it possible to mount the multiple components for which a single image is taken on a circuit board with high accuracy.

Also, it is preferable for the present invention to be equipped with a recognized position deviation amount measuring means for measuring the amount of deviation in the recognized position of the components being held by suction nozzles, and a memorizing means for memorizing the measured recognized position deviation amount data which is measured by the recognized position deviation amount measuring means; said recognized position deviation amount correction means correcting said deviation in the recognized position of the components being held on the suction nozzles by importing said data for the recognized position deviation amount from said memorizing means during production. By doing this, it is possible to measure the amount of deviation in the recognized position of the components due to the effects of the light source and to memorize this amount using the memorizing means before starting production, and then subsequently it is possible to accurately correct for the deviation in the recognized position of components due to the effects of the light source during production based on the recognized position deviation amount data memorized in the memorizing means.

Specifically, it is preferable to have a configuration in which the center of the camera field of view and the center of the light source are aligned, and, before starting production, to take an image of a component being held on a suction nozzle with the center of the suction nozzle and the center of the camera field of view aligned and to image process this image to recognize the position of the component; and also to move the suction nozzle to the position where the image is to be taken during production and to take an image of the component with the camera and vision process the image to recognize the position of the component; then to calculate said recognized position deviation amount as the difference between the distance that the suction nozzle was moved and the distance separating the two recognized position points. By doing this, it is possible to accurately measure the recognized position deviation amount before starting production.

In other words, it is preferable to create a memorizing means for memorizing a table containing recognized position deviation amounts as parameters which represent the positional relationship between a component being held on a suction nozzle and the light source; and to read the data for said recognized position deviation amount based on the positional relationship between the component being held on a suction nozzle and said light source from said table memorized in said memorizing means during production, and then to correct said deviation of the recognized position of the component being held on the suction nozzle. By doing this, the process for measuring the recognized position deviation amount before starting production can be omitted, therefore productivity is improved by this amount.

In this case, as in claim 3, it is preferable for a said table to be memorized for each type of component in said memorizing means, and during production the data for the said recognized position deviation amount based on the positional relationship between said component being held on a suction nozzle and said light source to be read from a table selected based on the component type at that time which is among the said tables for each component type memorized in the said memorizing means; and to use this data to correct the deviation in the recognized position of the component being held by the suction nozzle. By doing this, it is possible to accurately correct the deviation in the recognized position of various types of components.

BRIEF DESCRIPTION OF THE DRAWINGS

[FIG. 1] FIG. 1 is a perspective view showing the configuration of the modular component mounting system from embodiment 1 of the present invention.

[FIG. 2] FIG. 2 is a perspective view showing the XY-axis movement device which moves the mounting head in the X and Y directions.

[FIG. 3] FIG. 3 is a perspective view showing the camera and mounting head attachment configuration with respect to the second X-axis slide of the X-axis slide mechanism.

[FIG. 4] FIG. 4 is a cross-section view showing X-axis slide mechanism.

[FIG. 5] FIG. 5 is a perspective view showing the Y-axis slide mechanism and the X-axis slide mechanism configuration.

[FIG. 6] FIG. 6 is a cross-section view showing the positional arrangement of the lens, light source, and camera used for recognizing components.

[FIG. 7] FIG. 7 is a diagram to describe the processing procedure for measuring the deviation amount of the recognized position of components held on suction nozzles from embodiment 1 (part 1).

[FIG. 8] FIG. 8 is a diagram to describe the processing procedure for measuring the deviation amount of the recognized position of components held on suction nozzles from embodiment 1 (part 2).

[FIG. 9] FIG. 9 is a diagram to describe the processing procedure for measuring the deviation amount of the recognized position of components held on suction nozzles from embodiment 1 (part 3).

[FIG. 10] FIG. 10 is a diagram to describe the processing procedure for measuring the deviation amount of the recognized position of components held on suction nozzles from embodiment 1 (part 4).

[FIG. 11] FIG. 11 is a diagram to describe the processing procedure for measuring the deviation amount of the recognized position of components held on suction nozzles from embodiment 1 (part 5).

[FIG. 12] FIG. 12 is a flowchart to show the processing flow of the program for measuring the recognized position deviation amount of embodiment 1 (part 1).

[FIG. 13] FIG. 13 is a flowchart to show the processing flow of the program for measuring the recognized position deviation amount of embodiment 1 (part 2).

[FIG. 14] FIG. 14 is a flowchart to show the processing flow of the production program of embodiment 1.

[FIG. 15] FIG. 15 is a diagram to show conceptually the data tables for the recognized position deviation amounts of embodiment 2.

MODES FOR CARRYING OUT THE INVENTION

The following describes two modes for carrying out the invention, embodiment 1 and embodiment 2.

Embodiment 1

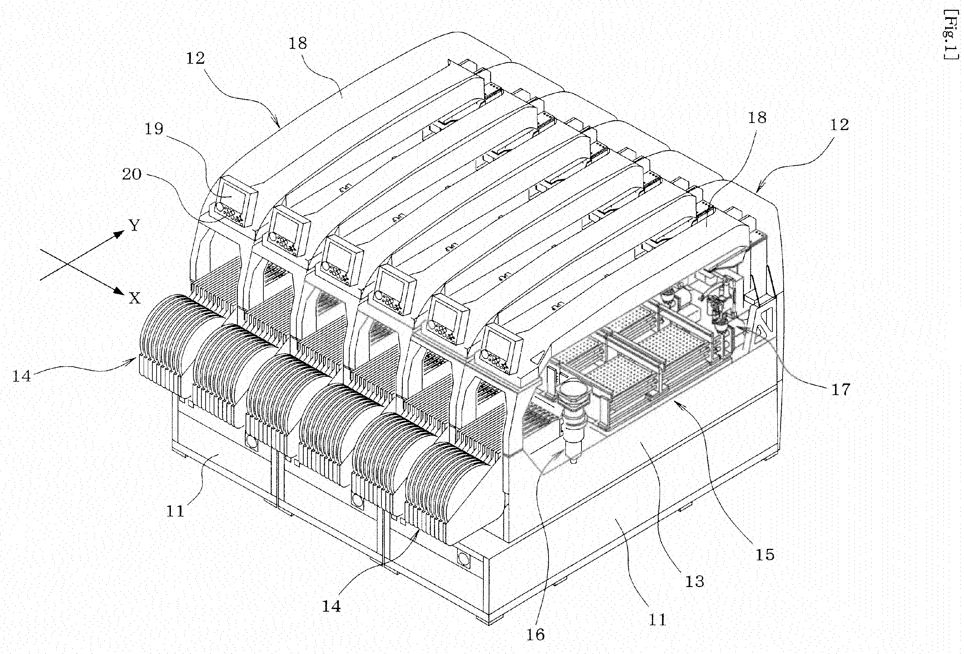

The following uses FIG. 1 to FIG. 14 to describe specific embodiment 1 of the present invention which is a modular component mounting system.

First, the following describes the configuration of the modular component mounting system using FIG. 1.

Multiple rotary head type (revolving head type) mounting modules 12 (component mounters) are exchangeably arranged next to each other on a base 11 of the modular component mounting system in the conveyance direction of the circuit boards. Each mounting module 12 has: feeders 14 (such as tape feeders), circuit board conveyance device 15, camera 16 for taking images of components, component mounting device 17, and other items on main bed 13; and display device 19 (such as an LCD display or CRT), and operation section 20 (such as operation buttons) on the front section of upper frame 18. In each mounting module 12, circuit boards are conveyed sequentially using circuit board conveyance device 15 and components are mounted on the circuit boards using component mounting device 17.

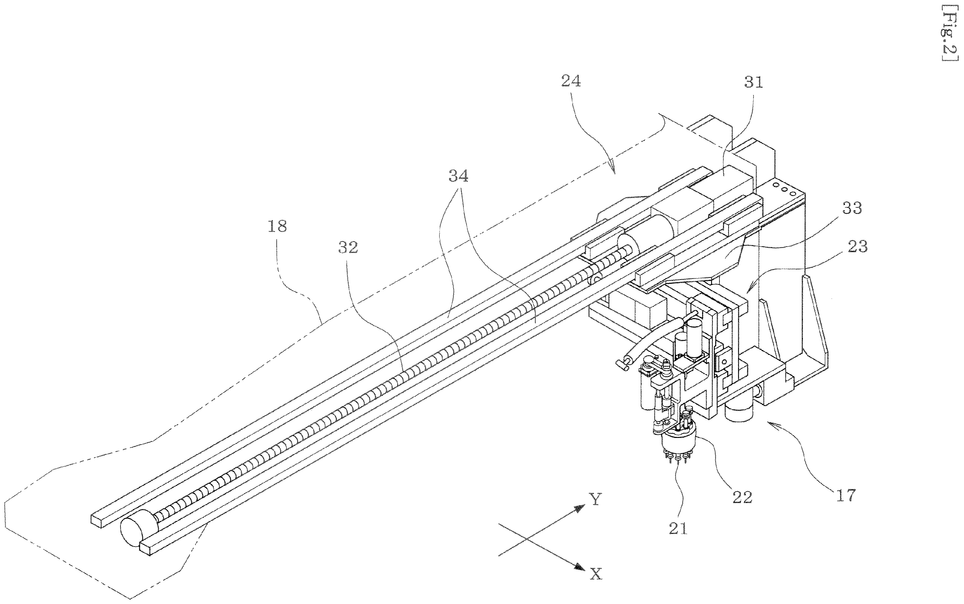

Next, the following describes the configuration of component mounting device 17 using FIG. 2 to FIG. 5.

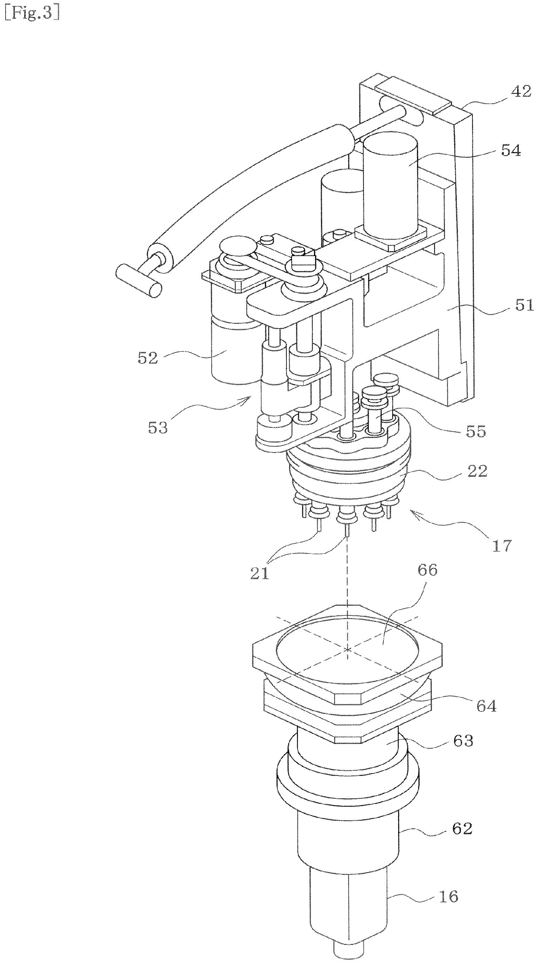

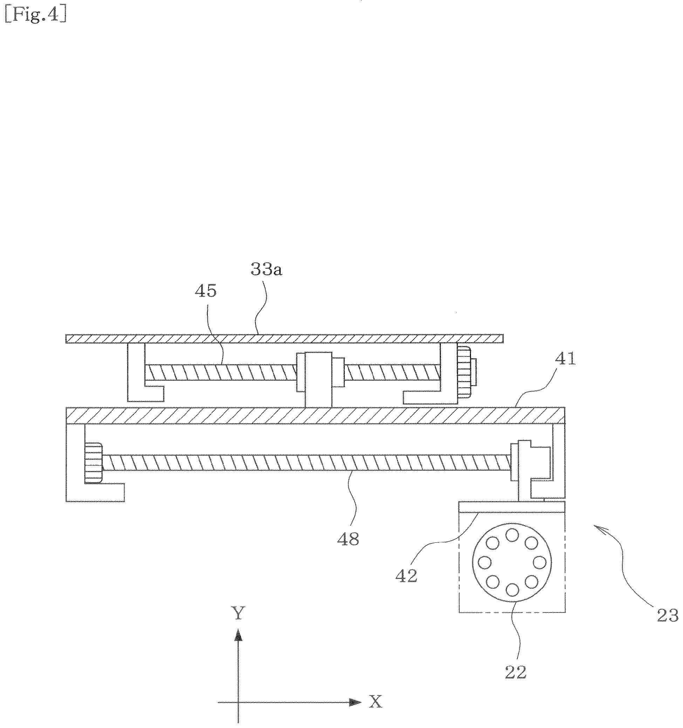

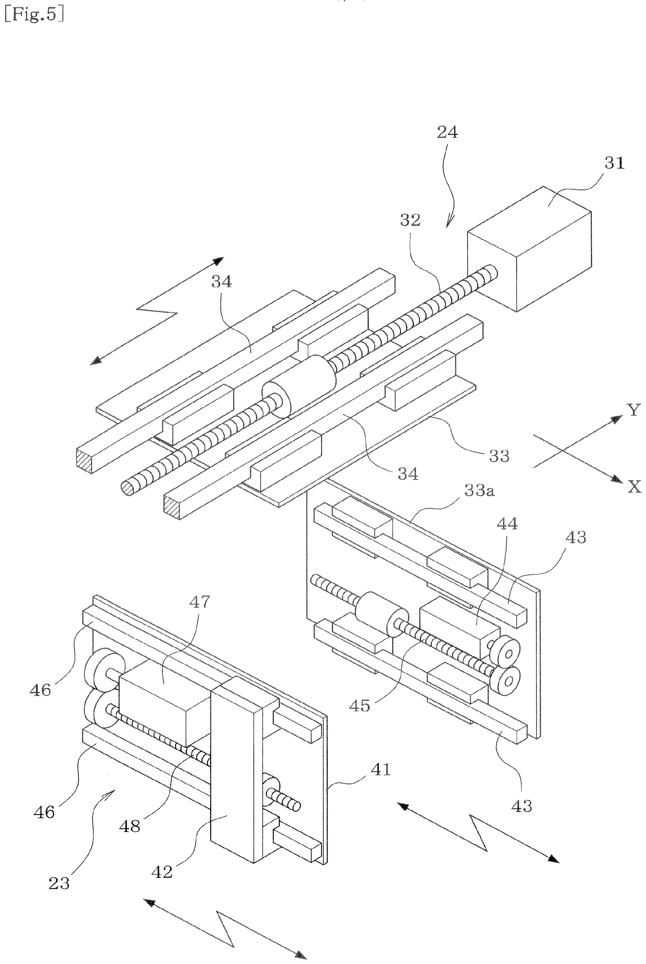

Here, FIG. 2 is a perspective view showing the XY-axis movement device which moves mounting head 22 in the X and Y directions; FIG. 3 is a perspective view showing the attachment configuration of mounting head 22 with respect to the second X-axis slide 42 of X-axis slide mechanism 23; FIG. 4 is a cross-section view showing the configuration of X-axis slide mechanism 23; FIG. 5 is a perspective view showing Y-axis slide mechanism 24 and the configuration of X-axis slide mechanism 23.

As shown in FIG. 2 and FIG. 3, component mounting device 17 consists of items such as rotary type (revolving type) mounting head 22 which has multiple exchangeable suction nozzles 21; X-axis slide mechanism 23 to move this mounting head 22 in the circuit board conveyance direction (hereafter this direction is defined as the "X-axis direction"); Y-axis slide mechanism 24 to move this X-axis slide mechanism 23 together with mounting head 22 in the Y-axis direction (the direction perpendicular to the circuit board conveyance direction); and nozzle raising and lowering mechanism 53 to raise and lower suction nozzles 21 of mounting head 22 when performing component pickup operation and mounting operation.

Y-axis slide mechanism 24 is configured such that Y-axis slide 33 is slid in the Y-axis direction along Y-axis guides 34 by the rotational movement of Y-axis ball screw 32 which is turned by Y-axis motor 31 which is attached to the upper frame 18 side of mounting module 12 (refer to FIG. 5).

Then, as shown in FIG. 4 and FIG. 5, X-axis slide mechanism 23 is configured such that it has a two-level slide mechanism consisting of the two X-axis slides 41 and 42, and the first X-axis slide 41 is slid in the X-axis direction along first guides 43 by the rotational movement of first X-axis ball screw 45 which is turned by first X-axis motor 44, wherein the first X-axis motor 44 and first guides 43 for guiding the first X-axis slide 41 in the X-axis direction are attached to supporting board 33a which is secured perpendicularly to Y-axis slide 33. It is also configured such that the second X-axis slide 42 is slid in the X-axis direction along second guides 46 by the rotational movement of second X-axis ball screw 48 which is turned by second X-axis motor 47, wherein the second X-axis motor 47 and second guides 46 for guiding the second X-axis slide 42 in the X-axis direction are attached to first X-axis slide 41.

As shown in FIG. 3, mounting head 22 is configured such that the circumference of the center axis of said mounting head 22 is rotated intermittently based on the pitch angle between suction nozzles 21 arranged on the head (pitch movement is performed) by motor 54 which is for rotating the head; wherein mounting head 22 is assembled to be able to be rotated on holding bracket 51 which is secured to second X-axis slide 42. On this mounting head 22, multiple nozzle holders 55 which hold pickup nozzles 21 are assembled so that they can be raised and lowered in the up/down direction (Z-direction); and, during component pickup and placement operation, a single nozzle holder 55 (suction nozzle 21) which is positioned at a specific component pickup and placement station is raised and lowered by nozzle raising and lowering mechanism 53 which has power provided by nozzle raising and lowering motor 52 (Z-axis motor).

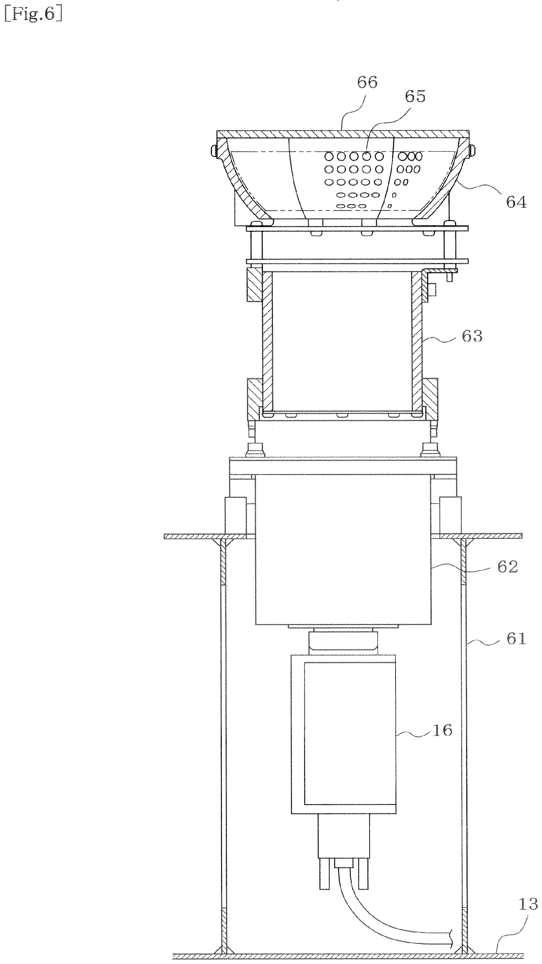

Then, as shown in FIG. 6, camera 16 for recognizing components is attached facing upwards to main bed 13 of mounting module 12 via supporting frame 61. The configuration is such that lens 62 is arranged directly above this camera 16; dome-shaped (bowl-shaped) light source 64 is attached directly above this lens 62 via box-shaped section 63; and the center of the field of view of camera 16 and the center of light source 64 are aligned. Multiple light-emitting elements 65 (such as LEDs) are arranged on the inner surface of the dome section of light source 64 such that, when images of components being held on suction nozzles 21 are taken by camera 16, the components are illuminated from below by light source 64. The upper surface of light source 64 is covered by transparent cover 66 through which the light passes.

Items such as X-axis slide mechanism 23, Y-axis slide mechanism 24, first X-axis motor 44 for moving nozzle raising and lowering mechanism 53, second X-axis motor 47, Y-axis motor 31, nozzle raising and lowering motor 52 (Z-axis motor), and motor 54 for rotating the head are controlled by the control device (computer) of mounting module 12. This control device of mounting module 12 functions as the image processing means which processes the image signal of camera 16 and recognizes the pickup position of components.

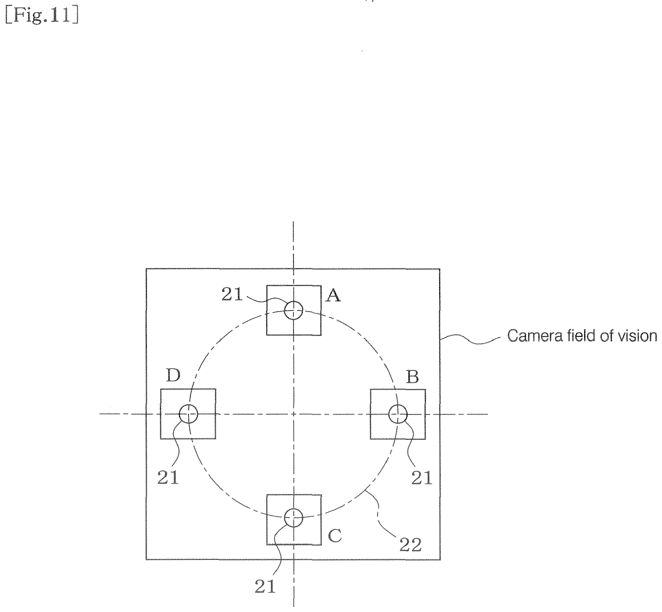

During operation of mounting module 12, each time a component supplied from a feeder 14 is picked up by a suction nozzle 21, mounting head 22 rotates only by the pitch angle amount (the movement pitch amount) of the arranged suction nozzles 21, and then repeats this so-called pickup operation for a component supplied from a feeder 14 using the next suction nozzle 21; after multiple suction nozzles 21 have each picked up a component, mounting head 22 is moved to the position for taking images during production at which a single image is to be taken for all components (the position in which the center of mounting head 22 is aligned with the center of the field of view of camera 16); then, as shown in FIG. 11, multiple suction nozzles 21 each holding one of the multiple components (A to D) are gathered in the field of view of camera 16 and a single image taken; then the image signal of camera 16 is processed, the pickup position of each component recognized, and the deviation of the pickup position of each component (the misalignment between the center of the component and the center of the pickup nozzle 21) is calculated; as well as this, mounting head 22 is moved directly above the mounting position of the components on the circuit board, and then each component is mounted on the circuit board considering the deviation in the pickup position of the components being held by each of the suction nozzles 21.

However, when gathering multiple components A to D within the field of vision of camera 16 and taking a single image of all the components after illuminating the multiple components A to D being held on multiple suction nozzles 21 from below using light source 64 (as shown in FIG. 11), this means that the image is taken with the position of each of the components A to D misaligned with the center of the field of view of camera 16 (the center of light source 64). If the components A to D of which an image is to be taken are BGA-type components, the pickup position of each of the components A to D is recognized by recognizing the bumps arranged in specific positions on the bottom surface of the component; however, because the position of each of the components A to D when the image is taken is misaligned with the center of the camera field of view (center of the light source), the light and dark condition (shading) of the bumps due to the illumination changes based on the distance from the center (the exposure angle with respect to the light source); as a result, the recognized position of each component A to D taken by the camera is deviated. Also, if the height position from the light source at which the image is taken changes, the exposure angle with respect to the light source changes, and the recognized position of each component A to D is deviated.

Also, there are cases in which the recognized position of each component A to D is deviated if the type of each component A to D is changed. For example, when recognizing the position of curved sections of components such as BGA-type components with bumps or the electrodes of chip capacitors, the light and dark condition (due to the light source) of the sections used for recognition changes based on the size of the curvature, and the recognized position of each component A to D is deviated. If the recognized position of each component A to D is deviated, the mounting position accuracy of each component A to D to be mounted on the circuit board deteriorates by that amount.

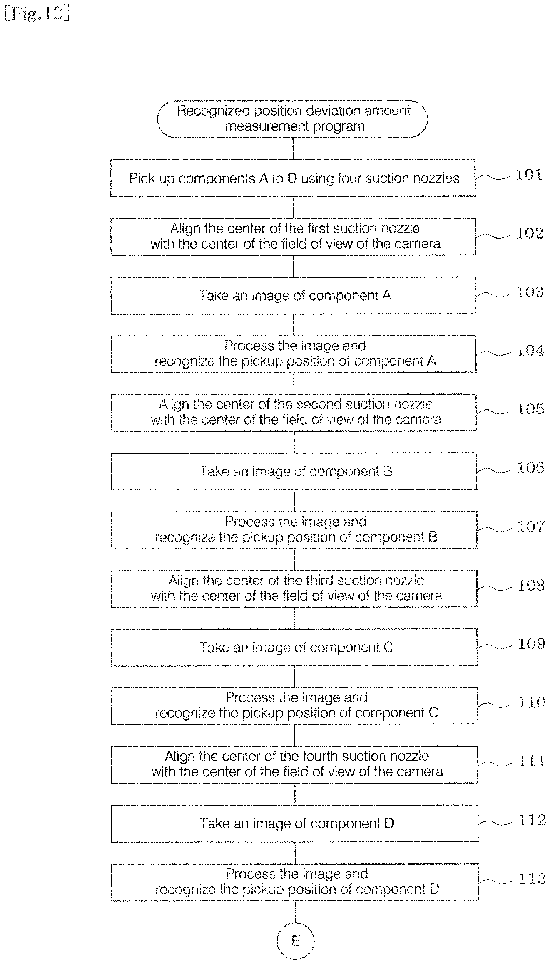

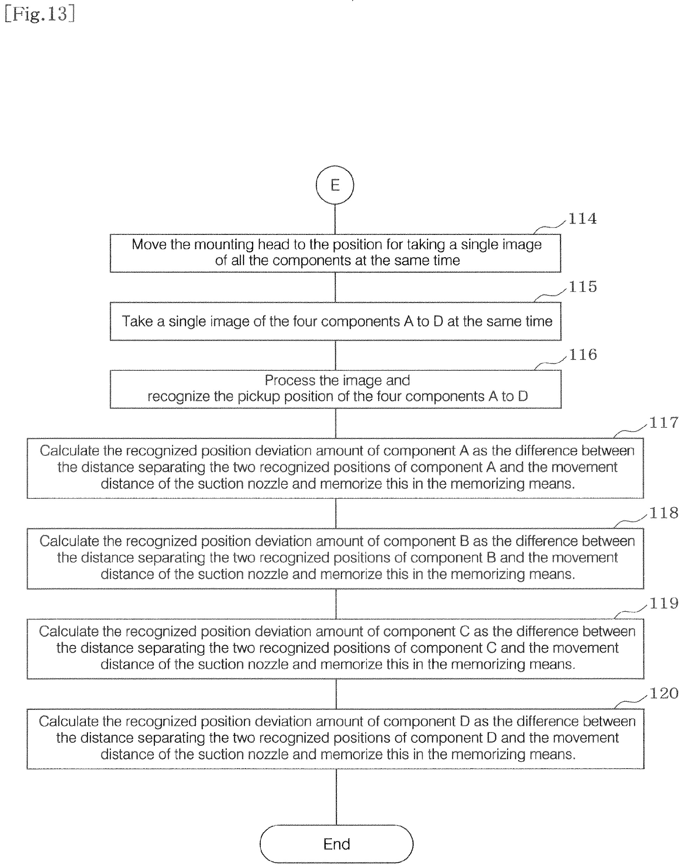

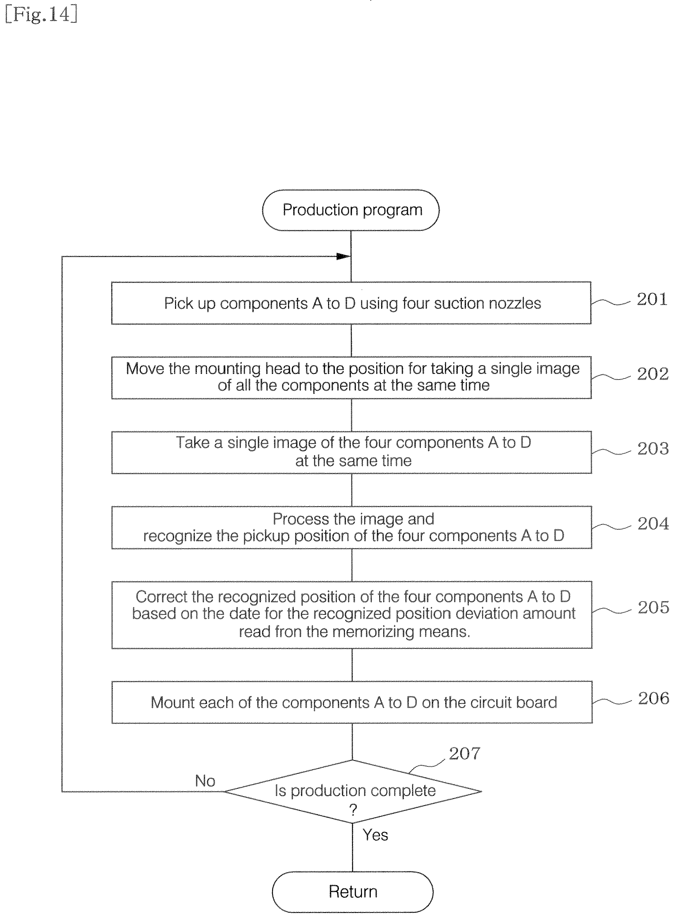

As a countermeasure to this, in embodiment 1 of the present invention, the control device of mounting module 12 is used to do the following: before starting production, by running the program for measuring the recognized position deviation amount from FIG. 12 and FIG. 13 described below, and by measuring before starting production each deviation amount of the recognized position of each of the multiple components A to D being held by multiple suction nozzles 21, then memorizing the measurement data in a memorizing means such as a hard disk or RAM, and then after that, by running the production program from FIG. 14 described below during production; correct the deviation in the recognized position of components A to D each being held by a suction nozzle 21 by reading the measurement data of the recognized position deviation amount from said memorizing means during production. Below uses each program flowchart from FIG. 12 to FIG. 14 to describe a control example when the quantity of suction nozzles on mounting head 22 is four.

Recognized position deviation amount measurement program

The recognized position deviation amount measurement programs from FIG. 12 and FIG. 13 are run before starting production using the control device of mounting module 12, and this performs the role of the recognized position deviation amount measurement means which measures the deviation amount of the recognized position of each of the components A to D being held by the four suction nozzles 21.

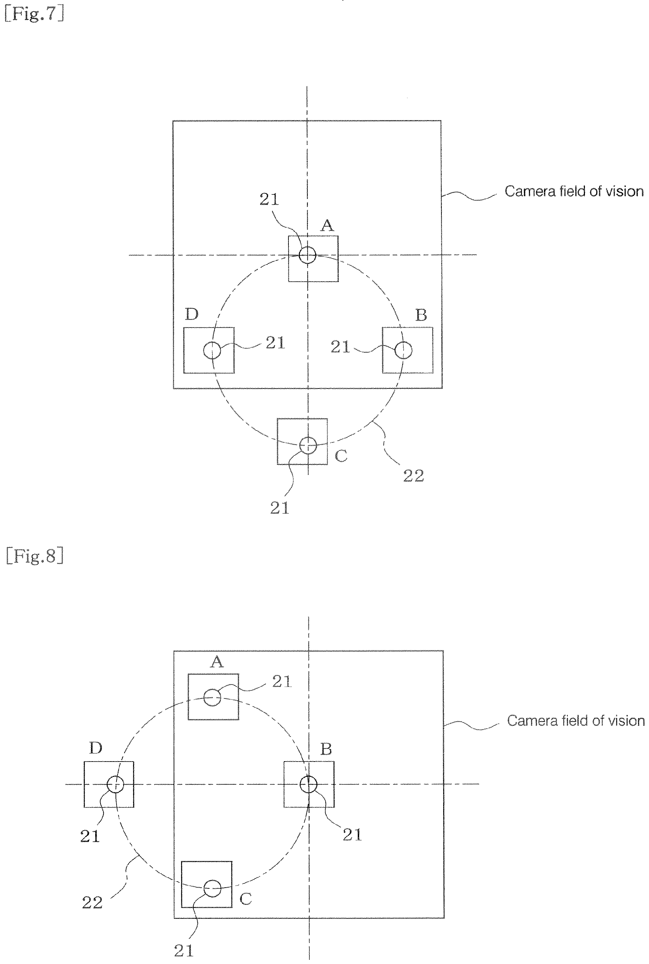

When this program is started, first, in step 101, each of the components A to D is picked up by the four suction nozzles 21. Then, continuing to step 102, as shown in FIG. 7, mounting head 22 is moved so that the center of the first suction nozzle 21 is aligned with the center of the field of view of camera 16 (the center of light source 64); and, in the next step 103, camera 16 takes an image of component A being held by said first suction nozzle 21 as it is illuminated from below by light source 64. Then, continuing to step 104, the image signal from camera 16 is processed and the pickup position (Xa1, Ya1) of component A being held on the first suction nozzle 21 is recognized and memorized using RAM or other such means. Here, the pickup position (Xa1, Ya1) of recognized component A is the center position of component A (hereafter the same). With this, the position of the sections of component A to be recognized (for example: in the case of a BGA-type component, the bumps; in the case of a chip capacitor, the terminals) are recognized, and the center position of component A is taken as the pickup position (Xa1, Ya1) (hereafter the same).

Then, continuing to step 105, as shown in FIG. 8, mounting head 22 is moved so that the center of the second suction nozzle 21 is aligned with the center of the field of view of camera 16 (the center of light source 64); and, in the next step 106, camera 16 takes an image of component B being held by said second suction nozzle 21 as it is illuminated from below by light source 64. Then, continuing to step 107, the image signal from camera 16 is processed and the pickup position (Xb1, Yb1) of component B being held on the second suction nozzle 21 is recognized and memorized using RAM or other such means.

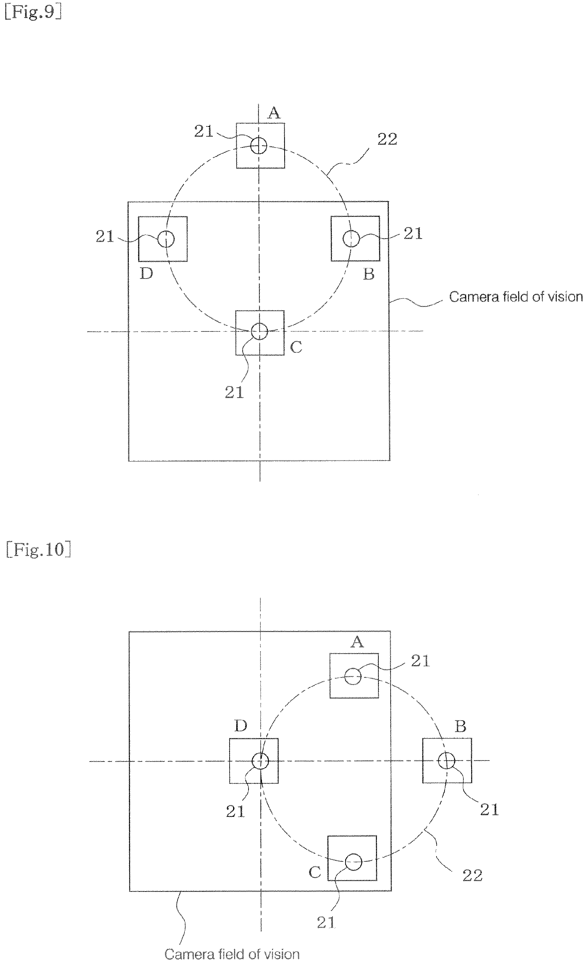

Then, continuing to step 108, as shown in FIG. 9, mounting head 22 is moved so that the center of the third suction nozzle 21 is aligned with the center of the field of view of camera 16 (the center of light source 64); and, in the next step 109, camera 16 takes an image of component C being held by said third suction nozzle 21 as it is illuminated from below by light source 64. Then, continuing to step 110, the image signal from camera 16 is processed and the pickup position (Xc1, Yc1) of component C being held on the third suction nozzle 21 is recognized and memorized using RAM or other such means.

Then, continuing to step 111, as shown in FIG. 8, mounting head 22 is moved so that the center of the fourth suction nozzle 21 is aligned with the center of the field of view of camera 16 (the center of light source 64); and, in the next step 112, camera 16 takes an image of component D being held by said fourth suction nozzle 21 as it is illuminated from below by light source 64. Then, continuing to step 113, the image signal from camera 16 is processed and the pickup position (Xd1, Yd1) of component D being held on the fourth suction nozzle 21 is recognized and memorized using RAM or other such means.

As given above, after recognizing each of the pickup positions of components A to D being held by the four suction nozzles 21, continuing to step 114 of FIG. 13, mounting head 22 is moved to the position for taking pictures during production which is the position for taking pictures of all the components at the same time (the position at which the center of mounting head 22 is aligned with the center of the field of view of camera 16); and, as shown in FIG. 11, the four components A to D being held on the four suction nozzles 21 are all gathered in the field of view of camera 16. Then, continuing to step 115, camera 16 takes a single image of all the components A to D being held by the four suction nozzles 21 while they are illuminated from below by light source 64; then, in the next step 116, the image signal from camera 16 is processed and the pickup positions of the four components A to D (Xa2, Ya2), (Xb2, Yb2), (Xc2, Yc2), (Xd2, Yd2) being held by the four suction nozzles 21 are recognized and memorized using RAM or other such means.

For the above, it is also acceptable to perform the processing for steps 114 to 116 (processing to recognize the pickup position of each component A to D after taking a single image of all four components A to D) before the processing for steps 102 to 113 (processing to recognize the pickup position of each of the components A to D after taking an individual image of each of those said components at the center of the field of view of camera 16).

Then, continuing to step 117, the distance ($\Delta Xa1.a2$, $\Delta Ya1.a2$) between the two recognized positions of component A (Xa1, Ya1), (Xa2, Ya2) being held on the first suction nozzle 21 is calculated.

$$\Delta Xa1.a2 = Xa1 - Xa2 \ldots \text{(distance in X direction)}$$

$$\Delta Ya1.a2 = Ya1 - Ya2 \ldots \text{(distance in Y direction)}$$

Also, the movement distance of the first suction nozzle 21 ($\Delta X1$, $\Delta Y1$) is calculated. If suction nozzle 21 is moved without rotating mounting head 22, the movement distance of suction nozzle 21 and the movement distance of mounting head 22 will be the same (hereafter the same).

And, the difference between the distance separating the two recognized positions of component A being held by first suction nozzle 21 and the movement distance of said suction nozzle 21 is calculated as the recognized position deviation amount of said component A and memorized using the memorizing means.

$$\text{Component A X-direction recognized position deviation amount} = \Delta Xa1.a2 - \Delta X1$$

$$\text{Component A Y-direction recognized position deviation amount} = \Delta Ya1.a2 - \Delta Y1$$

Next, continuing to step 118, along with calculating the distance ($\Delta Xb1.b2$, $\Delta Yb1.b2$) between the two recognized positions of component B (Xb1, Yb1), (Xb2, Yb2) being held on the second suction nozzle 21, the movement distance of the second suction nozzle 21 ($\Delta X2$, $\Delta Y2$) is calculated; the difference between these two distances is calculated as the recognized position deviation amount of component B and memorized using the memorizing means.

$$\text{Component B X-direction recognized position deviation amount} = \Delta Xb1.b2 - \Delta X2$$

$$\text{Component B Y-direction recognized position deviation amount} = \Delta Yb1.b2 - \Delta Y2$$

Next, continuing to step 119, along with calculating the distance ($\Delta Xc1.c2$, $\Delta Yc1.c2$) between the two recognized positions of component C (Xc1, Yc1), (Xc2, Yc2) being held on the third suction nozzle 21, the movement distance of the third suction nozzle 21 ($\Delta X3$, $\Delta Y3$) is calculated; the difference between these two distances is calculated as the recognized position deviation amount of component C and memorized using the memorizing means.

$$\text{Component C X-direction recognized position deviation amount} = \Delta Xc1.c2 - \Delta X3$$

$$\text{Component C Y-direction recognized position deviation amount} = \Delta Yc1.c2 - \Delta Y3$$

Next, continuing to step 120, along with calculating the distance ($\Delta Xd1.d2$, $\Delta Yd1.d2$) between the two recognized positions of component D (Xd1, Yd1), (Xd2, Yd2) being held on the fourth suction nozzle 21, the movement distance of the fourth suction nozzle 21 ($\Delta X4$, $\Delta Y4$) is calculated; the difference between these two distances is calculated as the recognized position deviation amount of component D and memorized using the memorizing means.

$$\text{Component D X-direction recognized position deviation amount} = \Delta Xd1.d2 - \Delta X4$$

$$\text{Component D Y-direction recognized position deviation amount} = \Delta Yd1.d2 - \Delta Y4$$

Production programs

The production program for FIG. 14 is run during production by the control device of mounting module 12. When this program is started, first, in step 201, each of the components A to D is picked up by the four suction nozzles 21. Next, continuing to step 202, mounting head 22 is moved to the position for taking pictures during production which is the position for taking pictures of all the components at the same time (the position at which the center of mounting head 22 is aligned with the center of the field of view of camera 16); and, as shown in FIG. 11, the four components A to D being held on the four suction nozzles 21 are all gathered in the field of view of camera 16.

Then, continuing to step 203, camera 16 takes a single image of all the components A to D being held by the four suction nozzles 21 while they are illuminated from below by light source 64; then, in the next step 204, the image signal from camera 16 is processed and the pickup positions of the four components A to D (Xa3, Ya3), (Xb3, Yb3), (Xc3, Yc3), (Xd3, Yd3) being held by the four suction nozzles 21 are recognized.

Next, continuing to step 205, each of the recognized positions for the four components A to D (Xa3, Ya3), (Xb3, Yb3), (Xc3, Yc3), (Xd3, Yd3) are corrected based on the following equations using the measurement data of the recognized position deviation amounts read from the memorizing means.

(1) Recognized position of component A after correction (Xa4, Ya4)

$$Xa4 = Xa3 - (\Delta Xa1.a2 - \Delta X1)$$

$$Ya4 = Ya3 - (\Delta Ya1.a2 - \Delta Y1)$$

(2) Recognized position of component B after correction (Xb4, Yb4)

$$Xb4 = Xb3 - (\Delta Xb1.b2 - \Delta X2)$$

$$Yb4 = Yb3 - (\Delta Yb1.b2 - \Delta Y2)$$

(3) Recognized position of component C after correction (Xc4, Yc4)

$$Xc4 = Xc3 - (\Delta Xc1.c2 - \Delta X3)$$

$$Yc4 = Yc3 - (\Delta Yc1.c2 - \Delta Y3)$$

(4) Recognized position of component D after correction (Xd4, Yd4)

$$Xd4 = Xd3 - (\Delta Xd1.d2 - \Delta X4)$$

$$Yd4 = Yd3 - (\Delta Yd1.d2 - \Delta Y4)$$

This step 205 processing performs the role of the recognized position deviation correction means mentioned in the scope of the patent claims.

Next, continuing to step 206, mounting head 22 is moved directly above the mounting position of the components on the circuit board, and then each component A to D is mounted on the circuit board considering the deviation in the pickup position of the components A to D being with respect to each of the suction nozzles 21.

Next, continuing to step 207, a judgment is made as to whether production has been completed, and if production has not been completed, the process returns to step 201 above. In this way, processing from steps 201 to 206 is run repeatedly during production. Next, in step 207 above, when production is judged to have been completed, the program finishes.

According to embodiment 1 described above, by measuring the amount of deviation in the recognized position of components due to the effects of the light source, and then memorizing that measurement data using a memorizing means before production, the measurement data for the recognized position deviation amount can be read from said memorizing means during production; this makes it possible to accurately correct for the deviation in the recognized position of components due to the effects of the light source based on the recognized position deviation amount data memorized in the memorizing means, and to improve the mounting position accuracy of the components mounted on the circuit board.

However, there are cases in which an image is taken by camera 16 of a single component being held by a single suction nozzle and the pickup position of that component recognized. In this case, it is possible to take the image with the single component being held by a single suction nozzle in the center of the camera 16 field of view (center of the light source). Therefore, when the component and the center of the camera 16 field of view are aligned, virtually no deviation arises in the recognized position of the component due to the effects of the light source, which means that there is no need to correct for the deviation in the recognized position of the component; however, when the component and the center of the camera 16 field of view are not aligned, a deviation does arise in the recognized position of the component due to the effects of the light source, which means that, by using the present invention, it is possible to correct for the deviation in the recognized position of the component due to the positional relationship of light source 64 and the component.

Furthermore, in step 205 of the production program from FIG. 14 mentioned above, correction of the recognized position of the four components A to D (Xa3, Ya3), (Xb3, Yb3), (Xc3, Yc3), (Xd3, Yd3) was performed using the measurement data of the recognized position deviation amounts read from the memorizing means; however, when mounting the same type of component at positions A to D using suction nozzles 21, it is also acceptable for a specific recognized position deviation amount for a component being held by a suction nozzle 21 to be used as a representative value, and by using this specific recognized position deviation amount for a component being held by a suction nozzle 21, the recognized position deviation amount for the other components being held by suction nozzles 21 can be calculated. This calculation method is described below.

$$\text{Component A X-direction recognized position deviation amount} = \Delta Xa1.a2 - \Delta X1 = CX1$$

$$\text{Component A Y-direction recognized position deviation amount} = \Delta Ya1.a2 - \Delta Y1 = CY1$$

$$\text{Component B X-direction recognized position deviation amount} = \Delta Xb1.b2 - \Delta X2 = CX2$$

$$\text{Component B Y-direction recognized position deviation amount} = \Delta Yb1.b2 - \Delta Y2 = CY2$$

If component B is arranged in a position rotated by angle $\theta AB$ (=90°) with respect to component A, component B Y-direction recognized position deviation amounts CX2, CY2 are calculated using component A X-direction recognized position deviation amounts CX1, CY1 according to the equations below.

$$CX2 = CX1 \times \cos\theta AB - CY1 \times \sin\theta AB$$

$$CY2 = CX1 \times \sin\theta AB + CY1 \times \cos\theta AB$$

In this way, it is acceptable to calculate the recognized position deviation amount of the other components being held on suction nozzles 21 by using the recognized position deviation amount of a specific component being held on a suction nozzle 21.

Embodiment 2

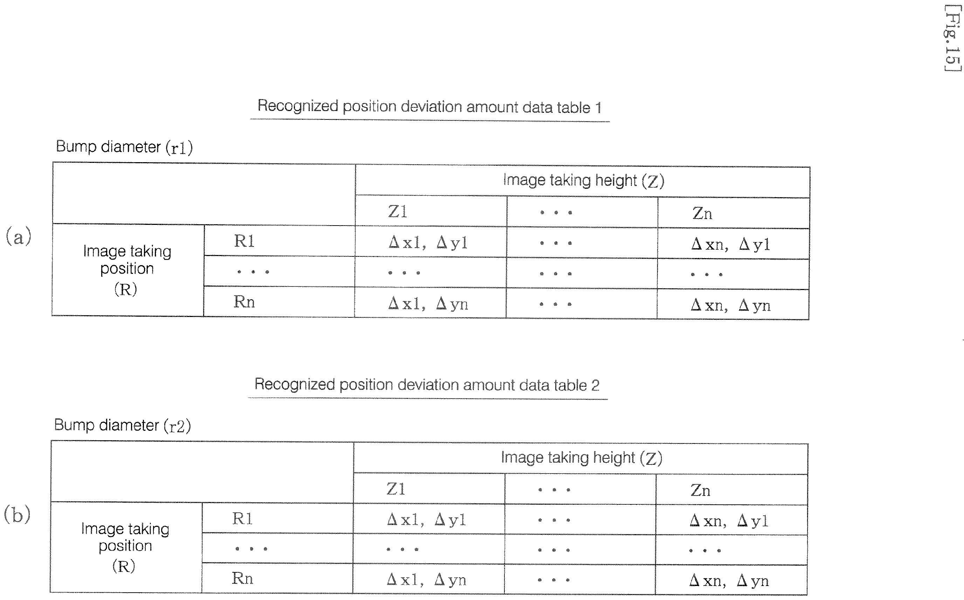

In embodiment 1 above, the amount of deviation in the recognized position of the components due to the effects of the light source was measured and this measurement data memorized using the memorizing means before starting production; however, in embodiment 2 of the present invention as shown in FIG. 15, a table containing recognized position deviation amounts as parameters which represent the positional relationship between a component being held on suction nozzles 21 and the light source 64 is memorized for each component type in a memorizing means, and correction is performed for the deviation in the recognized position of the component being held by a suction nozzle 21 by reading the data for the recognized position deviation amount based on the positional relationship between the components being held on suction nozzles 21 and light source 64 for the component type from a table selected based on the component type at that time which is among the tables for each component type memorized in the said memorizing means during production.

Here, it is acceptable to calculate the table data using mounting module 12 in the same method as in embodiment 1 above; or, it is acceptable to measure not actual components but jigs which simulate actual components; or, it is acceptable to make theoretical calculations considering the special characteristics of the deviation in the recognized position of a component.

This embodiment 2 uses the image taking position (R) and image taking height (Z) as parameters of the positional relationship between components being held on suction nozzles 21 and light source 64. The distance from the center of light source 64 to the sections of a component to be recognized (for example: in the case of a BGA-type component, the bumps; in the case of a chip capacitor, the terminals) is used for image taking position (R). The image taking height (Z) is the height from a reference position (for example, the position of camera 16) to the component. Also, the diameter or curvature of the sections of a component to be recognized (for example: in the case of a BGA-type component, the diameter of the bumps; in the case of a chip capacitor, the curvature of the terminals) are used as component type parameters.

In this embodiment 2, during production, after taking a single image of multiple components being held on multiple suction nozzles 21 at the same time, the deviation in the recognized position (X, Y) of the multiple components being held on multiple suction nozzles 21 is corrected by reading the data for the recognized position deviation amount ($\Delta x$, $\Delta y$) according to the image taking position (R) and image taking height (Z) from the selected from a table based on the diameter of the bumps (or curvature of the electrodes) of the component at that time, the table being selected from the multiple tables memorized in the memorizing means.

With embodiment 2 described above, the process for measuring the recognized position deviation amount before starting production can be omitted, therefore productivity is improved by this amount.

Furthermore, the present invention is not limited to a modular type component mounting system such as that shown in FIG. 1, and various modified embodiments which do not depart from the fundamental scope are possible, such as embodiments using various different type of component mounter.

SYMBOL DESCRIPTIONS

11: Base, 12: Mounting module (component mounter), 14: Feeder, 15: Circuit board conveyance device, 16: Camera, 17: Component mounting device, 21: Suction nozzle, 22: Mounting head, 23: X-axis slide mechanism; 24: Y-axis slide mechanism, 31: Y-axis motor, 33: Y-axis slide, 54: Motor for rotating head, 55: Nozzle holder, 52: Nozzle raising and lowering motor, 53: Nozzle raising and lowering mechanism, 62: Lens, 64: Light source, 65: Light emitting element, A to D: Components

**Claims**

1. A component mounter (12) which is equipped with a camera (16) to take images of components (A-D) being held on suction nozzles (21) illuminated by a light source (64) from below and an image processing means to process the image signal of said camera (16) in order to recognize the pickup position of the components (A-D); and which mounts said components on a circuit board considering the deviation of the pickup position of said components (A-D) with respect to said suction nozzles (21) based on the recognition results of the said image processing means; **characterized in that** the component mounter is equipped with a recognized position deviation correction means for correcting the deviation in the recognized position of said components (A-D) due to the positional relationship between the component (A-D) and the light source (64), wherein the position deviation correction means is configured to consider the deviation in the recognized position of said components (A-D) of which an image is taken by said camera (16) caused by the changing light and dark condition of the component (A-D) from said light source (64) due to the positional relationship between the light source (64) and said components (A-D) being held by the suction nozzles (21);

   wherein the field of view of the camera (16) and the center of the light source (64) are aligned;

   wherein the position deviation correction means is configured to correct the deviation in the recognized position of said components due to the positional relationship between the component (A-D) and the center of the light source (64), when an image is taken of all the components held by the nozzles (21) at the same time with the center of the mounting head (22) having the nozzles (21) being aligned with the center of the field of view of the camera (16) and the center of the light source (64);

   wherein the component mounter (12) comprises a memorizing means for memorizing the data of the recognized position deviation amount measured by a recognized position deviation amount measuring means or for memorizing tables containing said recognized position deviation amounts as parameters which represent the positional relationship between a component (A-D) being held on a suction nozzle (21) and said light source (64);

   wherein the said recognized position deviation correction means corrects the deviation in the recognized position of the components (A-D) being held by said suction nozzles (21) by reading the data of the recognized position deviation amount from the said memorizing means during production.

2. The component mounter (12) according to claim 1, **characterized in that** it is equipped with a recognized position deviation amount measuring means for measuring the deviation amount of the recognized position of the components (A-D) being held on the said suction nozzles (21).

3. The component mounter (12) according to claim 1, **characterized in that,** in said memorizing means, a said table is memorized for each component type,

   and said recognized position deviation correction means is configured to correct the deviation in the recognized position of said components (A-D) being held by suction nozzles (21) by reading the data of said recognized position deviation amounts which are based on the positional relationship of said light source (64) and said component (A-D) being held on a suction nozzle (21) from a table selected based on the component type at that time which is among the tables for each component type memorized in the memorizing means during production.

4. Method for obtaining recognized position deviation amounts using the component mounter (12) according to claim 2,**characterized in that** said method comprises:

   recognizing the position of components (A-D) using said image processing means by taking an image of the components (A-D) while they are being held on said suction nozzles (21) with the center of said suction nozzles (21) being aligned with the center of the field of view of said camera (16) before starting production, calculating said recognized position deviation amount as the difference between the movement distance of said nozzle (21) and the distance separating the two recognized positions of the component (A-D), which are recognized using the image processing means by moving the suction nozzle (21) to the position for taking images during production and taking an image of the component (A-D) using the camera (16).

**Patentansprüche**

1. Bauteil-Montagevorrichtung (12), die mit einer Kamera (16), die Bilder von Bauteilen (A-D) aufnimmt, die an Saugdüsen (21) gehalten werden, die mit einer Lichtquelle (64) von unten beleuchtet werden, sowie mit einer Bildverarbeitungs-Einrichtung ausgestattet ist, die das Bild-Signal der Kamera (16) verarbeitet, um die Aufnahme-Position der Bauteile (A-D) zu erkennen, und die die Bauteile unter Berücksichtigung der Abweichung der Aufnahme-Position der Bauteile (A-D) in Bezug auf die Saugdüsen (21) auf Basis der Erkennungsergebnisse der Bildverarbeitungs-Einrichtung montiert;

**dadurch gekennzeichnet, dass** die Bauteil-Montagevorrichtung mit einer Einrichtung zur Korrektur der erkannten Positionsabweichung versehen ist, mit der die Abweichung der erkannten Position der Bauteile (A-D) aufgrund der Positionsbeziehung zwischen dem Bauteil (A-D) und der Lichtquelle (64) korrigiert wird, wobei die Einrichtung zur Korrektur der erkannten Positionsabweichung so eingerichtet ist, dass sie die Abweichung der erkannten Position der Bauteile (A-D) berücksichtigt, deren Bild mit der Kamera (16) aufgenommen wird, die durch die Änderung eines Hell-Dunkel-Zustandes des Bauteils (A-D) durch die Lichtquelle (64) aufgrund der Positionsbeziehung zwischen der Lichtquelle (64) und den durch die Saugdüsen (21) gehaltenen Bauteile (A-D) verursacht wird;

wobei das Sichtfeld der Kamera (16) und der Mittelpunkt der Lichtquelle (64) fluchtend sind;

die Einrichtung zur Korrektur der erkannten Positionsabweichung so eingerichtet ist, dass sie die Abweichung der erkannten Position der Bauteile aufgrund der Positionsbeziehung zwischen dem Bauteil (A-D) und dem Mittelpunkt der Lichtquelle (64) korrigiert, wenn ein Bild aller der durch die Düsen (21) gehaltenen Bauteile zur gleichen Zeit aufgenommen wird und dabei der Mittelpunkt des Montage-Kopfes (22), der die Düsen (21) aufweist, mit dem Mittelpunkt des Sichtfeldes der Kamera (16) und dem Mittelpunkt der Lichtquelle (64) fluchtend ist;

die Bauteil-Montagevorrichtung (12) eine Speichereinrichtung umfasst, mit der die Daten der durch eine Einrichtung zum Messen des Maßes der erkannten Positionsabweichung gespeichert werden oder Tabellen gespeichert werden, die die Maße der erkannten Positionsabweichung als Parameter beinhalten, die die Positionsbeziehung zwischen einem an einer Saugdüse (21) gehaltenen Bauteil (A-D) und der Lichtquelle (64) repräsentieren;

die Einrichtung zur Korrektur der erkannten Positionsabweichung die Abweichung der erkannten Position der von den Saugdüsen (21) gehaltenen Bauteile (A-D) korrigiert, indem sie die Daten des Maßes der erkannten Positionsabweichung bei Herstellung aus der Speichereinrichtung liest.

2. Bauteil-Montagevorrichtung (12) nach Anspruch 1, **dadurch gekennzeichnet, dass** sie mit einer Einrichtung zum Messen des Maßes der erkannten Positionsabweichung ausgestattet ist, mit der das Maß der Abweichung der erkannten Position der an den Saugdüsen (21) gehaltenen Bauteile, (A-D) gemessen wird.

3. Bauteil-Montagevorrichtung (12) nach Anspruch 1, **dadurch gekennzeichnet, dass** in der Speichereinrichtung eine Tabelle für jeden Bauteil-Typ gespeichert ist,

und die Einrichtung zur Korrektur der erkannten Positionsabweichung so eingerichtet ist, dass sie die Abweichung der erkannten Position der durch die Saugdüsen (21) gehaltenen Bauteile (A-D) korrigiert, indem sie die Daten der Maße der erkannten Positionsabweichung liest, die auf der Positionsbeziehung der Lichtquelle (64) und des an einer Saugdüse (21) gehaltenen Bauteils (A-D) bei Herstellung aus einer Tabelle liest, die auf Basis des Bauteil-Typs zu diesem Zeitpunkt ausgewählt wird und zu den in der Speichereinrichtung gespeicherten Tabellen für jeden Bauteil-Typ gehört.

4. Verfahren zum Ermitteln von Maßen erkannter Positionsabweichung unter Verwendung der Bauteil-Montagevorrichtung (12) nach Anspruch 2, **dadurch gekennzeichnet, dass** das Verfahren umfasst:

Erkennen der Position von Bauteilen (A-D) unter Verwendung der Bildverarbeitungs-Einrichtung, indem ein Bild der Bauteile (A-D), während sie an den Saugdüsen (21) gehalten werden und dabei der Mittelpunkt der Saugdüsen (21) mit dem Mittelpunkt des Sichtfeldes der Kamera (16) fluchtend ist, vor Beginn der Herstellung aufgenommen wird, das Maß der erkannten Positionsabweichung als die Differenz zwischen der Bewegungsstrecke der Düse (21) und dem Abstand berechnet wird, der die zwei erkannten Positionen des Bauteils (A-D) trennt, die unter Verwendung der Bildverarbeitungs-Einrichtung erkannt werden, indem die Saugdüse (21) bei der Herstellung an die Position zum Aufnehmen von Bildern bewegt wird und ein Bild des Bauteils (A-D) unter Verwendung der Kamera (16) aufgenommen wird.

## Revendications

1. Dispositif de montage de composants (12) qui est équipé d'une caméra (16) pour prendre des images de composants (A-D) qui sont tenus sur des buses d'aspiration (21) éclairées par-dessous par une source lumineuse (64), et d'un moyen de traitement d'image pour traiter le signal d'image de ladite caméra (16) afin de reconnaître la position de prélèvement des composants (A-D) ; et qui monte lesdits composants sur une carte de circuit imprimé en prenant en compte l'écart de la position de prélèvement desdits composants (A-D) par rapport auxdites buses d'aspiration (21) sur la base des résultats de reconnaissance dudit moyen de traitement d'image ;

**caractérisé en ce que** le dispositif de montage de composants est équipé d'un moyen de correction d'écart de position reconnue permettant de corriger l'écart de la position reconnue desdits composants (A-D) dû à la relation de position entre le composant (A-D) et la source lumineuse (64), dans lequel le moyen de correction d'écart de position est conçu pour prendre en compte l'écart de la position reconnue desdits composants (A-D) dont une image est prise par ladite caméra (16), qui est causé par la variation de l'état éclairé/sombre du composant (A-D) résultant de ladite source lumineuse (64) et due à la relation de position entre la source lumineuse (64) et lesdits composants (A-D) qui sont tenus par les buses d'aspiration (21) ;

dans lequel le champ de vision de la caméra (16) et le centre de la source lumineuse (64) sont alignés ;

dans lequel le moyen de correction d'écart de position est conçu pour corriger l'écart de la position reconnue desdits composants dû à la relation de position entre le composant (A-D) et le centre de la source lumineuse (64), lorsqu'une image est prise de tous les composants tenus par les buses (21) simultanément alors que le centre de la tête de montage (22) portant les buses (21) est aligné avec le centre du champ de vision de la caméra (16) et le centre de la source lumineuse (64) ;

dans lequel le dispositif de montage de composants (12) comprend un moyen de mémorisation permettant de mémoriser les données de la grandeur d'écart de position reconnue mesurée par un moyen de mesure de grandeur d'écart de position reconnue ou de mémoriser des tables contenant lesdites grandeurs d'écart de position reconnue en tant que paramètres qui représentent la relation de position entre un composant (A-D) tenu sur une buse d'aspiration (21) et ladite source lumineuse (64) ;

dans lequel ledit moyen de correction d'écart de position reconnue corrige l'écart de la position reconnue des composants (A-D) qui sont tenus par lesdites buses d'aspiration (21) en lisant les données de la grandeur d'écart de position reconnue à partir dudit moyen de mémorisation pendant la production.

2. Dispositif de montage de composants (12) selon la revendication 1,
   **caractérisé en ce qu'**il est équipé d'un moyen de mesure de grandeur d'écart de position reconnue permettant de mesurer la grandeur d'écart de la position reconnue des composants (A-D) qui sont tenus sur lesdites buses d'aspiration (21).

3. Dispositif de montage de composants (12) selon la revendication 1,
   **caractérisé en ce que**, dans ledit moyen de mémorisation, une dite table est enregistrée pour chaque type de composant, et ledit moyen de correction d'écart de position reconnue est conçu pour corriger l'écart de la position reconnue desdits composants (A-D) qui sont tenus par les buses d'aspiration (21) en lisant les données desdites grandeurs d'écart de position reconnue qui sont basées sur la relation de position de ladite source lumineuse (64) et dudit composant (A-D) tenu sur une buse d'aspiration (21) dans une table sélectionnée en fonction du type de composant à ce moment, qui fait partie des tables correspondant à chaque type de composant qui sont enregistrées dans le moyen de mémorisation pendant la production.

4. Procédé d'obtention de grandeurs d'écart de position reconnue utilisant le dispositif de montage de composants (12) selon la revendication 2,
   **caractérisé en ce que** ledit procédé comprend :

   la reconnaissance de la position de composants (A-D) en utilisant ledit moyen de traitement d'image, consistant à prendre une image des composants (A-D) alors qu'ils sont tenus sur lesdites buses d'aspiration (21), le centre desdites buses d'aspiration (21) étant aligné avec le centre du champ de vision de ladite caméra (16) avant de démarrer la production,

   le calcul de ladite grandeur d'écart de position reconnue en tant que différence entre la distance de déplacement de ladite buse (21) et la distance séparant les deux positions reconnues du composant (A-D), qui sont reconnues à l'aide du moyen de traitement d'image en déplaçant la buse d'aspiration (21) vers la position de prise d'images pendant la production et en prenant une image du composant (A-D) au moyen de la caméra (16).

[Fig.1]

[Fig.2]

EP 2 699 069 B1

[Fig.3]

[Fig.4]

[Fig.5]

[Fig.6]

[Fig.7]

Camera field of vision

[Fig.8]

Camera field of vision

[Fig.9]

21
A
22

21
D
B
21

Camera field of vision

C
21

[Fig.10]

A
21

D
B
21

21

C
22

21

Camera field of vision

[Fig.11]

21

A

Camera field of vision

D

B

21

21

C

22

21

[Fig.12]

Recognized position deviation amount
measurement program

Pick up components A to D using four suction nozzles — 101

Align the center of the first suction nozzle
with the center of the field of view of the camera — 102

Take an image of component A — 103

Process the image and
recognize the pickup position of component A — 104

Align the center of the second suction nozzle
with the center of the field of view of the camera — 105

Take an image of component B — 106

Process the image and
recognize the pickup position of component B — 107

Align the center of the third suction nozzle
with the center of the field of view of the camera — 108

Take an image of component C — 109

Process the image and
recognize the pickup position of component C — 110

Align the center of the fourth suction nozzle
with the center of the field of view of the camera — 111

Take an image of component D — 112

Process the image and
recognize the pickup position of component D — 113

E

[Fig.13]

```
                    ┌───┐
                    │ E │
                    └─┬─┘
                      │                                    ╭──114
   ┌──────────────────┴──────────────────────────────┐
   │ Move the mounting head to the position for taking a single image │
   │        of all the components at the same time     │
   └──────────────────┬──────────────────────────────┘
                      │                                    ╭──115
   ┌──────────────────┴──────────────────────────────┐
   │ Take a single image of the four components A to D at the same time │
   └──────────────────┬──────────────────────────────┘
                      │                                    ╭──116
   ┌──────────────────┴──────────────────────────────┐
   │                  Process the image and            │
   │    recognize the pickup position of the four components A to D │
   └──────────────────┬──────────────────────────────┘
```

Move the mounting head to the position for taking a single image of all the components at the same time — 114

Take a single image of the four components A to D at the same time — 115

Process the image and recognize the pickup position of the four components A to D — 116

Calculate the recognized position deviation amount of component A as the difference between the distance separating the two recognized positions of component A and the movement distance of the suction nozzle and memorize this in the memorizing means. — 117

Calculate the recognized position deviation amount of component B as the difference between the distance separating the two recognized positions of component B and the movement distance of the suction nozzle and memorize this in the memorizing means. — 118

Calculate the recognized position deviation amount of component C as the difference between the distance separating the two recognized positions of component C and the movement distance of the suction nozzle and memorize this in the memorizing means. — 119

Calculate the recognized position deviation amount of component D as the difference between the distance separating the two recognized positions of component D and the movement distance of the suction nozzle and memorize this in the memorizing means. — 120

End

[Fig.14]

```
                    ( Production program )
                            │
            ┌───────────────┤
            │               ▼
            │   ┌────────────────────────────────────────────────┐
            │   │  Pick up components A to D using four suction   │ ～ 201
            │   │  nozzles                                        │
            │   └────────────────────────────────────────────────┘
            │               │
            │   ┌────────────────────────────────────────────────┐
            │   │  Move the mounting head to the position for     │ ～ 202
            │   │  taking a single image of all the components    │
            │   │  at the same time                               │
            │   └────────────────────────────────────────────────┘
            │               │
            │   ┌────────────────────────────────────────────────┐
            │   │  Take a single image of the four components     │ ～ 203
            │   │  A to D at the same time                        │
            │   └────────────────────────────────────────────────┘
            │               │
            │   ┌────────────────────────────────────────────────┐
            │   │  Process the image and recognize the pickup     │ ～ 204
            │   │  position of the four components A to D          │
            │   └────────────────────────────────────────────────┘
            │               │
            │   ┌────────────────────────────────────────────────┐
            │   │  Correct the recognized position of the four    │ ～ 205
            │   │  components A to D based on the date for the     │
            │   │  recognized position deviation amount read      │
            │   │  fron the memorizing means.                     │
            │   └────────────────────────────────────────────────┘
            │               │
            │   ┌────────────────────────────────────────────────┐
            │   │  Mount each of the components A to D on the      │ ～ 206
            │   │  circuit board                                  │
            │   └────────────────────────────────────────────────┘
            │               │
            │               ▼          207
            │        ◇ Is production ◇
            └── No ──◇   complete     ◇
                     ◇      ?         ◇
                            │ Yes
                            ▼
                        ( Return )
```

[Fig. 15]

EP 2 699 069 B1

Recognized position deviation amount data table 1

Bump diameter (r1)

(a)

| | | Image taking height (Z) | | |
|---|---|---|---|---|
| | | Z1 | · · · | Zn |
| Image taking position (R) | R1 | $\Delta$x1, $\Delta$y1 | · · · | $\Delta$xn, $\Delta$y1 |
| | · · · | · · · | · · · | · · · |
| | Rn | $\Delta$x1, $\Delta$yn | · · · | $\Delta$xn, $\Delta$yn |

Recognized position deviation amount data table 2

Bump diameter (r2)

(b)

| | | Image taking height (Z) | | |
|---|---|---|---|---|
| | | Z1 | · · · | Zn |
| Image taking position (R) | R1 | $\Delta$x1, $\Delta$y1 | · · · | $\Delta$xn, $\Delta$y1 |
| | · · · | · · · | · · · | · · · |
| | Rn | $\Delta$x1, $\Delta$yn | · · · | $\Delta$xn, $\Delta$yn |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2001001167 A1
- JP H07307598 A
- JP 2007103436 A
- JP 2010199630 A